# EUROPÄISCHE PATENTSCHRIFT

(11) **EP 3 361 273 B1**
(45) Veröffentlichungstag und Bekanntmachung des Hinweises auf die Patenterteilung: **30.10.2019**
(21) Anmeldenummer: 17205184.9
(22) Anmeldetag: 04.12.2017
(51) Int. Cl.: G01R 31/02, H02H 3/16, H02H 3/40

(54) **VERFAHREN ZUR STEUERUNG EINES DISTANZSCHUTZRELAIS DURCH ERKENNUNG VON LEITER-ERDE-FEHLERN**
METHOD FOR CONTROLLING A DISTANCE PROTECTION RELAY BY DETECTING CONDUCTOR EARTH FAULTS
PROCÉDÉ DE COMMANDE D'UN RELAIS DE PROTECTION DISTANT PAR DÉTECTION DE DÉFAUTS PHASE-TERRE

(30) Priorität: 09.02.2017 AT 501072017
(43) Veröffentlichungstag der Anmeldung: 15.08.2018
(73) Patentinhaber: Sprecher Automation GmbH, 4020 Linz (AT)
(72) Erfinder: Liebermann, Carlo, 01307 Dresden (DE); Meyer, Jörg, 01157 Dresden (DE); Kleemann, Michael, 12524 Berlin (DE)
(74) Vertreter: Hübscher & Partner Patentanwälte GmbH

(56) Entgegenhaltungen:
- EP-A2- 1 195 874
- US-B2- 8 717 036

## Beschreibung

Die Erfindung bezieht sich auf ein Verfahren zur Steuerung eines Distanzschutzrelais durch Erkennung von Leiter-Erde-Fehlern in einem Mehrphasenstromnetz, wobei für jede Phase mit Hilfe einer Strommessvorrichtung zunächst der in der Phase fließende Leiterstrom sowie mit Hilfe einer Spannungsmessvorrichtung die Leiter-Erde-Spannung zwischen dem Potential der Phase und dem Erdpotential gemessen, beide Signale einem Analog-/Digitalwandler zugeführt werden und zeitdiskrete Werte des Erdstromes ermittelt werden.

Zur Absicherung von Mehrphasenstromnetzen sind Distanzschutzrelais bekannt, die ein Netzsegment in Abhängigkeit von der Entfernung zu einer Fehlerstelle früher oder später abschalten. Proportional zu der Entfernung zur Fehlerstelle ist die jeweilige Leitungsimpedanz, also im Falle eines Leiter-Leiter-Fehlers die Impedanz der resultierenden Leiter-Leiter-Schleife und im Falle eines Leiter-Erde-Fehlers die Impedanz der jeweiligen Leiter-Erde-Schleife. Diese sogenannte Mitimpedanz berechnet sich aus dem Quotienten zwischen der jeweiligen Leiter-Erde-Spannung und der Differenz zwischen Leiterstrom und dem mit dem komplexen Erdfaktor multiplizierten Erdstrom. Der Erdfaktor kann folglich nur berücksichtigt werden, wenn die Leiter-Erde-Spannungen, die Leiterströme sowie der Erdstrom als komplexe Größen zur Verfügung stehen, was die Erfassung deren komplexen Zeiger durch Filteralgorithmen oder eine Fourier-Analyse erforderlich machen. Derartige Verfahren zur Bestimmung der komplexen Größen dieser Signale sind sehr rechenintensiv und benötigen jedenfalls eine Periode Grundschwingung des Signals, sodass sich eine entsprechende Zeitverzögerung in der Reaktionsgeschwindigkeit eines auf derartigen Algorithmen basierenden Distanzschutzrelais ergibt. Folgende Dokumente zeigen Distanzschutzrelais: EP1195874A2 und US8717036B2.

Eine Berücksichtigung des komplexen Erdfaktors ist für den Fachmann bei diesen Verfahren nur insofern möglich, als entweder nur der Betrag des Erdfaktors und das komplexe Zeigerargument durch zeitliche Verschiebung der zugeordneten zeitdiskreten Werten der abgetasteten Signale berücksichtigt wird oder das Signal des Erdstroms mit dem Betrag des Realteils des Erdfaktors multipliziert und der Imaginärteil durch Multiplikation des um 90° gedrehten und mit dem reziproken Wert der Kreisfrequenz multiplizierten Signals, also des zeitlichen Verlaufs des Erdstromes berücksichtigt wird, was üblicherweise durch numerische Differentiation erfolgt.

Nachteilig ist am ersten Verfahren, dass für eine Verschiebung der zeitdiskreten Werte der abgetasteten Signale um nichtganzzahlige Abtastpunkte bzw um Zeiten, die zwischen zwei vorgegebenen Abtastzeitpunkten liegen, eine numerische Approximation des Signalverlaufes erfolgen muss, was bei einer Approximation mit Polynomen zu einem hohen numerischen Rechenaufwand und bei einer lediglich linearen Approximation zu hohen Abweichungen in der Impedanzberechnung führt. Weist der Erdfaktor zudem ein positives Argument auf, sind für die Berechnung Abtastzeitpunkte erforderlich, die in der Zukunft liegen, sodass es schon allein aus diesem Grund zu einer Verzögerung der Impedanzbestimmung kommt.

Das zweite Verfahren bringt den Nachteil mit sich, dass eine exakte Impedanzberechnung nur bei rein sinusförmigen Signalen möglich ist und bei einer variablen bzw. abklingenden Gleichstromkomponente, wie sie im Kurzschlussfall zu erwarten ist, oder im Fall von Oberschwingungen bei der numerischen Differentiation eine Verstärkung von Spektralanteilen mit einer Kreisfrequenz größer 1 auftritt. Zudem kommt es auch hier zu einer Zeitverzögerung um zumindest ein Abtastintervall.

Der Erfindung liegt somit die Aufgabe zugrunde, ein Verfahren zur Steuerung eines Distanzschutzrelais der eingangs beschriebenen Art so auszugestalten, dass eine Auslösung des Relais aufgrund von Leiter-Erde-Fehlern schnell und zuverlässig bei Verarbeitung zeitdiskreter Werte erfolgen kann, ohne dass hierfür spezielle Prozessoren für die Berechnung erforderlich werden.

Die Erfindung löst die gestellte Aufgabe dadurch, dass für jede Phase zeitdiskrete Werte der Leiteradmittanz aus den zugeordneten zeitdiskreten Werten der abgetasteten Signale von Leiterstrom und Leiter-Erde-Spannung und zeitdiskrete Werte der Erdadmittanz aus den zugeordneten zeitdiskreten Werten des Erdstromes und des abgetasteten Signals der jeweiligen Leiter-Erde-Spannung ermittelt, die zeitdiskreten Werte der Erdamittanz und ein für ein Segment des Mehrphasenstromnetzes charakteristischer vorgegebener komplexer Erdfaktor einem Multiplizierer zugeführt, das komplexe zeitdiskrete Ausgangssignal des Multiplizierers mit den zugeordneten zeitdiskreten Werten der Leiteradmittanz zu den komplexen zeitdiskreten Werten der Admittanz der Leiter-Erde-Schleife summiert und das Distanzschutzrelais ausgelöst wird, wenn die komplexen zeitdiskreten Werten der Admittanz der Leiter-Erde-Schleife außerhalb eines vorgegebenen komplexen Normwertebereiches liegen.

Durch die Ermittlung von Leiteradmittanz und Erdadmittanz im Gegensatz zur direkten Berechnung der Mitimpedanz bei für den Fachmann bekannten Verfahren kann die Admittanz der Leiter-Erd-Schleife durch Summieren der Leiteradmittanz und der mit dem komplexen Erdfaktor multiplizierten Erdadmittanz bestimmt werden. Leiteradmittanz und Erdadmittanz können dabei anders als bei bekannten Verfahren unabhängig voneinander bestimmt werden, solange lediglich eine Zuordnung der zeitdiskreten Werte möglich bleibt. Die Multiplikation der Erdadmittanz mit dem komplexen Erdfaktor erfolgt erst in einem darauffolgenden Schritt, bevor das komplexe zeitdiskrete Ausgangssignal des Multiplizierers mit den zugeordneten zeitdiskreten Werten der Leiteradmittanz summiert wird. Dabei ist zu beachten, dass Leiterstrom und Erdstrom in entgegengesetzte Richtungen fließen und somit unterschiedliche Vorzeichen aufweisen müssen, sodass auch Leiteradmittanz und Erdadmittanz folglich unterschiedliche Vorzeichen besitzen. Weiters ist es für den Fachmann selbstverständlich, dass der Erdstrom entweder direkt gemessen oder beispielsweise durch die negative Summe der einzelnen Leiterströme ermittelt werden kann. Durch die erfindungsgemäßen Maßnahmen kann die Berücksichtigung des komplexen Erdfaktors für eine zuverlässige Auslösung des Distanzschutzrelais auch bei einer zeitdiskreten Abtastung der zugrundeliegenden elektrischen Signale des Netzes erfolgen, wobei eine Zeitverzögerung in der Auslösung durch eine Polynom-Approximation oder eine numerische Differentiation wie in der Einleitung beschrieben vermieden wird.

Um eine Kompatibilität mit herkömmlichen Steuergeräten zu ermöglichen, können aus den komplexen zeitdiskreten Werten der Admittanz der Leiter-Erde-Schleife durch Invertieren die zeitdiskreten Werte der Mitimpedanz der Leiter-Erde-Schleife bestimmt werden, wonach das Distanzschutzrelais ausgelöst wird, wenn die Mitimpedanz außerhalb eines vorgegebenen komplexen Normwertebereiches liegt.

Besonders vorteilhafte Voraussetzungen ergeben sich für die Durchführung des erfindungsgemäßen Verfahrens, wenn die Leiteradmittanz durch Invertieren der aus den zugeordneten zeitdiskreten Werten der abgetasteten Signale von Leiterstrom und Leiter-Erde-Spannung ermittelten Leiterimpedanz bestimmt wird. Zufolge dieser Maßnahme können zur Berechnung der zeitdiskreten Werte der Leiteradmittanz bekannte Verfahren wie beispielsweise das Verfahren von Lobos oder Mcinnes und Morrison angewendet werden.

Gleiches gilt selbstverständlich auch für den Fall, dass die Erdadmittanz durch Invertieren der aus den zugeordneten zeitdiskreten Werten des Erdstromes und des abgetasteten Signals der jeweiligen Leiter-Erde-Spannung ermittelten Erdimpedanz bestimmt wird.

In der Zeichnung ist der Erfindungsgegenstand beispielsweise dargestellt. Es zeigen
- Fig. 1: ein schematisches Blockschaltbild eines erfindungsgemäßen Distanzschutzrelais,
- Fig. 2: das Diagramm eines Zeitverlaufes von Real- und Imaginäranteil der gemäß dem erfindungsgemäßen Verfahren bestimmten Mitimpedanz eines vollverlagerten Kurzschlussstromes im Vergleich mit anderen bekannten Verfahren gemäß Beispiel 1 und
- Fig. 3: ein der Fig. 2 entsprechedes Diagramm bei überlagertem Spektralanteil dritter Ordnung gemäß Beispiel 2.

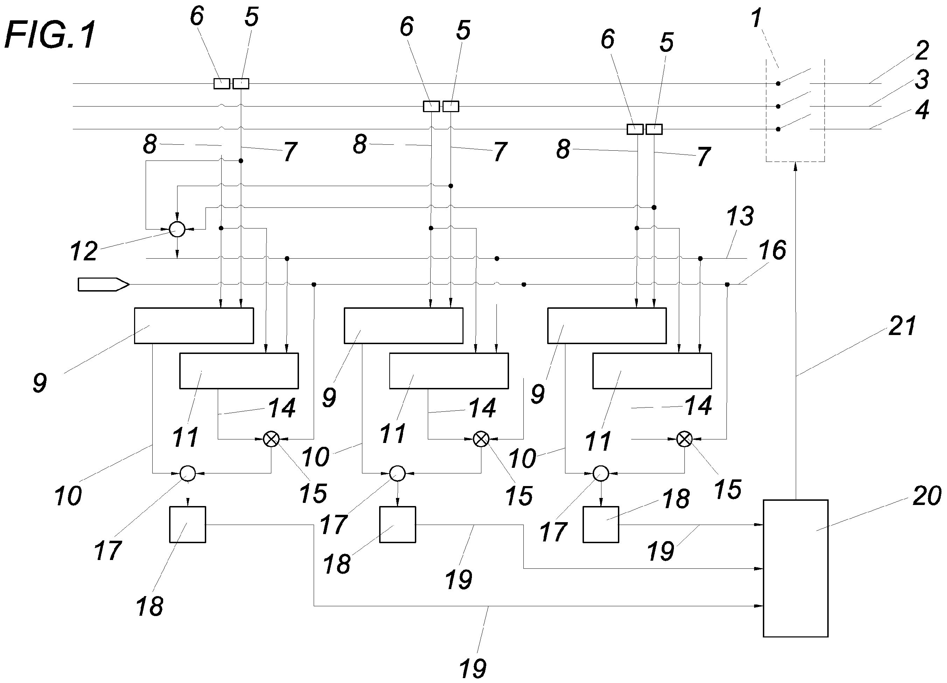

Ein Distanzschutzrelais zur Durchführung des erfindungsgemäßen Verfahrens umfasst nach Fig. 1 eine Schalteinheit 1 zur Unterbrechung der drei Phasen 2, 3, 4 eines Drehstromnetzes, wobei das erfindungsgemäße Verfahren selbstverständlich unabhängig von der Anzahl der Phasen des Stromnetzes und damit beispielsweise auch bei einphasigen Stromnetzes angewendet werden kann. Die Phasen 2, 3, 4 können in der Schalteinheit 1 einzeln oder in Gruppen abgeschaltet werden. Für jede der drei Phasen 2, 3 und 4 ist je eine Strommessvorrichtung 5 zur Messung des in der Phase 2, 3, 4 fließenden Leiterstromes sowie eine Spannungsmessvorrichtung 6 zur Messung der jeweiligen Leiter-Erde-Spannung zwischen dem Potential der Phase und dem Erdpotential vorgesehen. Die Strommessvorrichtungen 5 und die Spannungsmessvorrichtungen 6 weisen im dargestellten Ausführungsbeispiel einen integrierten Analog-/Digitalwandler auf, dessen Abtastzeitpunkte über eine nicht näher dargestellte Synchronisationseinrichtung mit den Abtastzeitpunkten der übrigen Analog-/Digitalwandler synchronisiert werden. Die zeitdiskreten Werte der abgetasteten Signale der Leiterströme werden über Datenleitungen 7, die zeitdiskreten Werte der abgetasteten Signale der Leiter-Erde-Spannungen über Datenleitungen 8 Leiteradmittanzberechnern 9 zugeführt, an deren Ausgang jeweils eine Datenleitung 10 für die Leiteradmittanz angeschlossen ist.

Die zeitdiskreten Werte der abgetasteten Signale der Leiter-Erde-Spannungen werden über die Datenleitungen 8 nicht nur den Leiteradmittanzberechnern 9, sondern auch Erdadmittanzberechnern 11 zugeführt. Diese benötigen als Eingang auch zeitdiskrete Werte des Erdstromes, der im Ausführungsbeispiel der Fig. 1 über einen Summierer 12 aus den zeitdiskreten Werten der abgetasteten Signale der Leiterströme gewonnen wird und über die Datenleitungen 13 den Erdadmittanzberechnern 11 zur Verfügung gestellt wird, an deren Ausgang jeweils eine Datenleitung 14 für die Erdadmittanz angeschlossen ist.

Die Datenleitungen 14 führen zu je einem Multiplizierer 15 je Phase 2, 3, 4, der die Erdadmittanz mit einem für das zu überwachende Segment des Mehrphasenstromnetzes charakteristischen, über die Datenleitungen 16 verteilten, vorgegebenen und komplexen Erstromfaktor multipliziert. Die komplexen zeitdiskreten Ausgangssignale der Multiplizierer 15 werden mittels Summierern 17 mit den zugeordneten zeitdiskreten Werten der Leiteradmittanzen, die an den Datenleitungen 10 anliegen, summiert, sodass an den Ausgängen der Summierer 17 jeweils die zeitdiskreten komplexen Werte der Admittanz der jeweiligen Leiter-Erd-Schleife anliegen, die über nachgeschaltete Invertierer 18 in die entsprechenden zeitdiskreten komplexen Werte der Mitimpedanz der jeweiligen Leiter-Erd-Schleife umgewandelt werden. Diese zeitdiskreten komplexen Werte der Mitimpedanzen werden über Datenleitungen 19 einer Steuerung 20 zugeführt, in der ein Vergleich der anliegenden komplexen Mitimpedanz je Phase 2, 3, 4 mit einem vorgegebenen komplexen Normwertebereich durchgeführt wird. Liegt die anliegende komplexen Mitimpedanz außerhalb des Normwertebereiches, löst die Steuerung 20 über eine Steuerleitung 21 die Schalteinheit 1 aus, die die betroffene Phase 2, 3, 4 trennt.

Gemäß einer alternativen Ausführungsform der Erfindung können auch direkt die zeitdiskreten komplexen Werte der Admittanz der jeweiligen Leiter-Erd-Schleife der Steuerung 20 zugeführt werden, wenn diese einen Vergleich mit einem vorgegebenen komplexen Normwertebereich für Admittanzen durchführt.

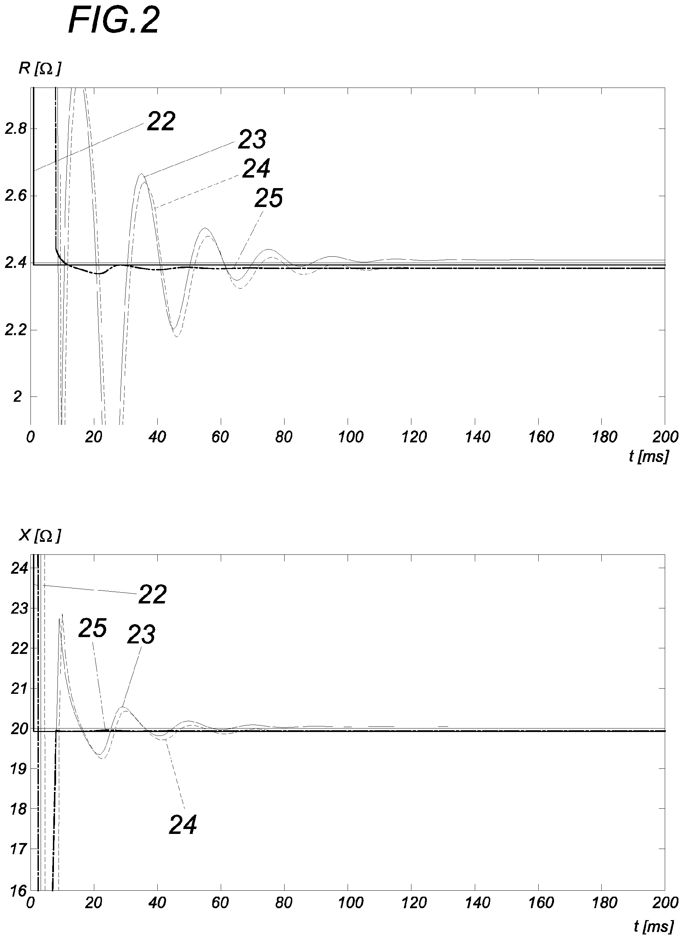

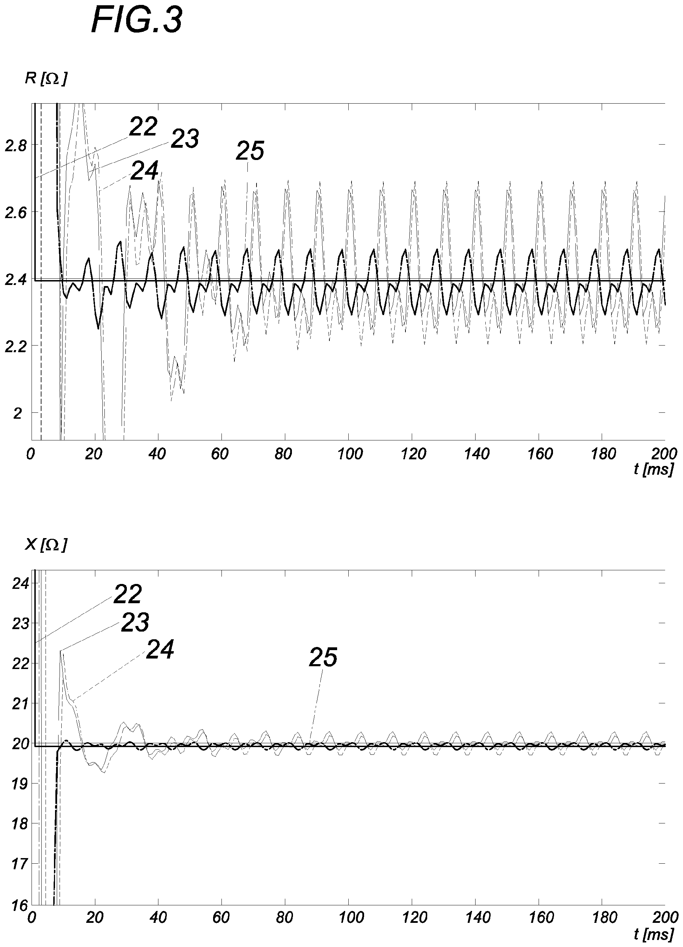

Die Fig. 2 und 3 zeigen eine Gegenüberstellung des zeitlichen Verlaufes der zeitdiskreten komplexen Werte der Mitimpedanzen jeweils im Vergleich mit dem Referenzwert 22 und dem Berechnungsergebnis der in der Einleitung genannten bekannten Verfahren. Fig. 2 zeigt dabei in einem ersten Beispiel den Fall eines vollverlagerten Kurzschlussstromes, Fig. 3 in einem zweiten Beispiel den Fall einer Überlagerung des vollverlagerten Kurschlussstromes mit einem Spektralanteil dritter Ordnung. Die Darstellung erfolgt jeweils getrennt nach Realteil R und Imaginärteil X der komplexen Mitimpedanz.

Wird nur der Betrag des Erdfaktors und das komplexe Zeigerargument durch zeitliche Verschiebung der zugeordneten zeitdiskreten Werten der abgetasteten Signale berücksichtigt, ergibt sich der zeitliche Verlauf 23, wie er den Fig. 2 und 3 entnommen werden kann.

Wird das Signal des Erdstroms mit dem Betrag des Realteils des Erdfaktors multipliziert und der Imaginärteil durch Multiplikation des um 90° gedrehten und mit dem reziproken Wert der Kreisfrequenz multiplizierten Signals, also des zeitlichen Verlaufs des Erdstromes durch numerische Differentiation berücksichtigt, ergibt sich der in den Fig. 2 und 3 dargestellte zeitliche Verlauf 24.

Vergleicht man die zeitlichen Verläufe der in der Einleitung geschilderten, aus dem Stand der Technik bekannten Verfahren mit dem erfindungsgemäßen Verfahren, zeigt sich, dass der zeitliche Verlauf 25 der mit dem erfindungsgemäßen Verfahren ermittelten zeitdiskreten komplexen Werte der Mitimpedanzen im Beispiel 1 deutlich rascher mit dem tatsächlichen Referenzwert 22 konvergiert und sowohl in Beispiel 1 als auch in Beispiel 2 ein wesentlich geringeres Überschwingverhalten aufweist.

## Patentansprüche

1. Verfahren zur Steuerung eines Distanzschutzrelais durch Erkennung von Leiter-Erde-Fehlern in einem Mehrphasenstromnetz, wobei für jede Phase (2, 3, 4) mit Hilfe einer Strommessvorrichtung (5) zunächst der in der Phase (2, 3, 4) fließende Leiterstrom sowie mit Hilfe einer Spannungsmessvorrichtung (6) die Leiter-Erde-Spannung zwischen dem Potential der Phase (2, 3, 4) und dem Erdpotential gemessen, beide Signale einem Analog-/Digitalwandler zugeführt werden und zeitdiskrete Werte des Erdstromes ermittelt werden, **dadurch gekennzeichnet, dass** für jede Phase (2, 3, 4) zeitdiskrete Werte der Leiteradmittanz aus den zugeordneten zeitdiskreten Werten der abgetasteten Signale von Leiterstrom und Leiter-Erde-Spannung und zeitdiskrete Werte der Erdadmittanz aus den zugeordneten zeitdiskreten Werten des Erdstromes und des abgetasteten Signals der jeweiligen Leiter-Erde-Spannung ermittelt, die zeitdiskreten Werte der Erdamittanz und ein für ein Segment des Mehrphasenstromnetzes charakteristischer vorgegebener komplexer Erdfaktor einem Multiplizierer (15) zugeführt, das komplexe zeitdiskrete Ausgangssignal des Multiplizierers (15) mit den zugeordneten zeitdiskreten Werten der Leiteradmittanz zu den komplexen zeitdiskreten Werten der Admittanz der Leiter-Erde-Schleife summiert und das Distanzschutzrelais ausgelöst wird, wenn die komplexen zeitdiskreten Werten der Admittanz der Leiter-Erde-Schleife außerhalb eines vorgegebenen komplexen Normwertebereiches liegen.

2. Verfahren nach Anspruch 1, **dadurch gekennzeichnet, dass** aus den Werten der komplexen zeitdiskreten Admittanz der Leiter-Erde-Schleife durch Invertieren die zeitdiskreten Werte der Mitimpedanz der Leiter-Erde-Schleife bestimmt werden, wonach das Distanzschutzrelais ausgelöst wird, wenn die Mitimpedanz außerhalb eines vorgegebenen komplexen Normwertebereiches liegt.

3. Verfahren nach Anspruch 1 oder 2, **dadurch gekennzeichnet, dass** die Leiteradmittanz durch Invertieren der aus den zugeordneten zeitdiskreten Werten der abgetasteten Signale von Leiterstrom und Leiter-Erde-Spannung ermittelten Leiterimpedanz bestimmt wird.

4. Verfahren nach einem der Ansprüche 1 bis 3, **dadurch gekennzeichnet, dass** die Erdadmittanz durch Invertieren der aus den zugeordneten zeitdiskreten Werten des Erdstromes und des abgetasteten Signals der jeweiligen Leiter-Erde-Spannung ermittelten Erdimpedanz bestimmt wird.

## Claims

1. Method for controlling a distance protection relay by detecting conductor-earth faults in a multiphase power supply system, wherein, for each phase (2, 3, 4), initially the conductor current flowing in the phase (2, 3, 4) is measured with the aid of a current measuring device (5) and the conductor-earth voltage between the potential of the phase (2, 3, 4) and the earth potential is measured with the aid of a voltage measuring device (6), both signals are supplied to an analogue/digital converter and time-discrete values of the earth current are ascertained, **characterised in that**, for each phase (2, 3, 4), time-discrete values of the conductor admittance are ascertained from the allocated, time-discrete values of the scanned signals of the conductor current and conductor-earth voltage and time-discrete values of the earth admittance are ascertained from the allocated, time-discrete values of the earth current and the scanned signal of the respective conductor-earth voltage, the time-discrete values of the earth admittance and a specified complex earth factor characteristic of a segment of the multiphase power supply system is supplied to a multiplier (15), the complex, time-discrete output signal of the multiplier (15) is summed with the allocated, time-discrete values of the conductor admittance to produce the complex, time-discrete values of the admittance of the conductor-earth loop and the distance protection relay is triggered if the complex, time-discrete values of the admittance of the conductor-earth loop are outside a specified, complex standard value range.

2. Method as claimed in claim 1, **characterised in that** the time-discrete values of the positive sequence impedance of the conductor-earth loop are determined from the values of the complex, time-discrete admittance of the conductor-earth loop by means of inversion, after which the distance protection relay is triggered if the positive sequence impedance is outside a specified, complex standard value range.

3. Method as claimed in claim 1 or 2, **characterised in that** the conductor admittance is determined by inverting the conductor impedance which is ascertained from the allocated, time-discrete values of the scanned signals of the conductor current and conductor-earth voltage.

4. Method as claimed in any one of claims 1 to 3, **characterised in that** the earth admittance is determined by inverting the earth impedance which is ascertained from the allocated, time-discrete values of the earth current and the scanned signal of the respective conductor-earth voltage.

## Revendications

1. Procédé de commande d'un relais de protection de distance par détection de défauts phase-terre dans un réseau de courant multiphasé, dans lequel, pour chaque phase (2, 3, 4), le courant conducteur présent dans la phase (2, 3, 4) est d'abord mesuré à l'aide d'un dispositif de mesure de courant (5), et la tension conducteur-terre entre le potentiel de la phase (2, 3, 4) et le potentiel de terre est mesurée à l'aide d'un dispositif de mesure de tension (6), les deux signaux sont transmis à un convertisseur analogique/numérique et des valeurs discrètes dans le temps du courant de terre sont déterminées, **caractérisé en ce que**, pour chaque phase (2, 3, 4), sont déterminées des valeurs discrètes dans le temps de l'admittance de conducteur à partir des valeurs discrètes dans le temps associées, des signaux échantillonnés de courant conducteur et de tension conducteur-terre et des valeurs discrètes dans le temps de l'admittance de terre à partir des valeurs discrètes dans le temps associées, du courant de terre et du signal échantillonné de chaque tension conducteur-terre, les valeurs discrètes dans le temps de l'admittance de terre et un facteur de terre complexe prédéterminé caractéristique d'un segment du réseau de courant multiphasé sont fournis à un multiplicateur (15), le signal de sortie discret dans le temps complexe du multiplicateur (15) est additionné avec les valeurs discrètes dans le temps associées, de l'admittance de conducteur pour former les valeurs discrètes dans le temps complexes, de l'admittance de la boucle terre-conducteur et le relais de protection de distance est déclenché si les valeurs discrètes dans le temps complexes, de l'admittance de la boucle terre-conducteur se trouvent en dehors d'une plage de valeurs standard complexes prédéterminée.

2. Procédé selon la revendication 1, **caractérisé en ce que** les valeurs discrètes dans le temps de l'impédance directe de la boucle terre-conducteur sont définies par inversion à partir des valeurs de l'admittance discrète dans le temps complexe, de la boucle terre-conducteur, à la suite de quoi le relais de protection de distance est déclenché, si l'impédance directe se situe en dehors d'une plage de valeurs standard complexes prédéterminée.

3. Procédé selon la revendication 1 ou 2, **caractérisé en ce que** l'admittance de conducteur est définie par inversion des valeurs discrètes dans le temps associées, des signaux échantillonnés de courant conducteur et tension conducteur-terre de l'impédance de conducteur déterminée.

4. Procédé selon l'une des revendications 1 à 3, **caractérisé en ce que** l'admittance de terre est définie par inversion des valeurs discrètes dans le temps associées, du courant de terre et du signal échantillonné de la tension conducteur-terre respective de l'impédance de terre déterminée.
